# EUROPEAN PATENT APPLICATION

(11) **EP 0 691 577 A1**
(43) Date of publication of application: **10.01.1996**
(21) Application number: 95201272.2
(22) Date of filing: 16.05.1995
(51) Int. Cl.: G03F 7/07, H04N 1/40, G03F 5/00

(54) **Method for making a lithographic printing plate**

(30) Priority: 06.07.1994 EP 94201942
(71) Applicant: AGFA-GEVAERT naamloze vennootschap, B-2640 Mortsel (BE)
(72) Inventor: Van Rompuy, Ludo, c/o Agfa-Gevaert N.V:, B-2640 Mortsel (BE); Van Hunsel, Johan, c/o Agfa-Gevaert N.V:, B-2640 Mortsel (BE)

(57) **Abstract**

There is provided a method for making a lithographic printing plate from an original containing continuous tones comprising the steps of:
- frequency modulation screening said original to obtain screened data
- image-wise exposing according to said screened data a negative working photosensitive lithographic printing plate precursor containing a photosensitive layer comprising a direct positive silver halide emulsion and an image receiving layer comprising physical development nuclei in water permeable contact with each other, said lithographic printing plate precursor having a surface capable of being differentiated in ink accepting and ink repellant areas upon said image-wise exposure and an development step and
- developing a thus obtained image-wise exposed lithographic printing plate precursor using an alkaline processing liquid in the presence of developing agent(s) and silver halide solvent(s), characterized in that said photosensitive layer comprises a spectrally sensitized prefogged direct positive silver halide emulsion with exterior electron-traps whereof the amount of silver bromide lies in the range between 0.5 mole/mole AgX and 5 mole/mole AgX.

## Description

### 1. Field of the invention.

The Present invention relates to a method for making a negative working lithographic printing plate, in particular to a method comprising a frequency modulation screening of the original.

### 2. Background of the invention.

Lithographic printing is the process of printing from specially prepared surfaces, some areas of which are capable of accepting ink (oleophilic areas) whereas other areas will not accept ink (oleophobic areas). The oleophilic areas form the printing areas while the oleophobic areas form the background areas.

Lithographic printing plates can be prepared using a photosensitive lithographic printing plate precursor, also called imaging element. Such imaging element is exposed in accordance with the image data and is generally developed thereafter so that a differentiation results in ink accepting properties between the exposed and unexposed areas.

From the above it will be clear that lithographic printing is only capable of reproducing two tone values because the areas will accept ink or not. Thus lithographic printing is a so called binary process. In order to reproduce originals having continuously changing tone values by such process halftone screening techniques are applied.

In a commonly used halftone screening technique, the continuously changing tone values of the original are modulated with periodically changing tone values of a superimposed two-dimensional screen. The modulated tone values are then subject to a thresholding process wherein tone values above the treshold value will be reproduced and those below will not be reproduced. The process of tone-value modulation and thresholding results in a two-dimensional arrangement of equally spaced "screen dots" whose dimensions are proportional to the tone value of the original at that particular location. The number of screen dots per unit distance determines the screen frequency or screen ruling. This screening technique wherein the screen frequency is constant and inversely proportional to the halftone cell size, is referred to as amplitude-modulation screening or autotypical screening. This technique can be implemented photo-mechanically or electronically.

It will further be clear that in order to reproduce a color image using lithographic printing it will be required to separated the image in three or more part-images corresponding to primary colors that when printed over each other yield the desired color at any place within the image. Each of these color separation has to be screened as described above.

It is well known that the above described procedure of screening results in certain artifacts on a copy obtained in lithographic printing. Such artifacts are e.g. enlarging of the screen dots on the press, Moiré patterns, color shifts, etc..

A lot of variants of the dot size modulation screening have been disclosed in order to remedy these artifacts but none of them was capable of completely eliminating the enlarging of the screen dots on the press and the Moiré patterns and dot frequency modulation screening techniques have therefore been suggested to further reduce the problem.

According to frequency modulation screening the distance between the halftone dots is modulated rather then their size. This technique, although well known in the field of low resolution plain paper printers, has only recently obtained much attention for offset printing and other high end printing methods.

Methods for making a lithographic printing plate comprising the steps of frequency modulation screening an original to obtain screened data and image-wise exposing an imaging element according to said screened data, said exposure being scan-wise and/or said imaging element having a flexible support have been disclosed in e.g. EP-A 93201114.1 and EP-A 93201115.8. Negative working as well as positive working imaging elements are disclosed.

A great part of the commercially used photosensitive lithographic printing plate precursors are of the negative working type. In a negative working imaging element a negative image is formed in the printing plate (the printing areas being considered as the image areas) while in a positive working imaging element a positive image is formed in the printing plate. The term negative image means that image reversal occurred while the term positive image indicates that no image reversal took place.

Examples of negative working photosensitive lithographic printing plate precursors, also called pre-sensitized (hereinafter called PS-) plates, as disclosed in said EP-A 93201114.1 and EP-A 93201115.8 are imaging elements having a photosensitive layer containing diazonium salts or a diazo resin as described in e.g. EP-A-450199 and imaging elements having a photosensitive layer containing a photopolymerizable composition as described in e.g. EP-A-502562, EP-A-491457, EP-A-503602, EP-A-471483 or DE-A-4102173.

It is required that the obtained printing plates have good printing properties e.g. a high printing endurance, good ink acceptance in the printing areas and no ink acceptance in the non-printing areas (no staining). Further the printing plates should have a low dot gain. Indeed in the case of a large dot gain considerable tone value corrections are needed on the original photographic film, causing a undesirable decrease of the grey values that can be reproduced. It is furthermore desirable that the printing plate exhibits a high resolving power.

However, it was found that when negative working PS plates are used to reproduce frequency modulation screened images (typically with an elementary dot of 14-21 µm), a large dot gain is obtained in the printed copy.

### 3. Summary of invention.

It is an object of the present invention to provide a method for making an improved lithographic printing plate having a low dot gain and a high printing endurance using a negative working photosensitive lithographic printing plate precursor having a high sensitivity, being easy to prepare and giving reproducible results and wherein the continuous tone original is frequency modulation screened.

Further objects of the present invention will become clear from the description hereinafter.

According to the present invention there is provided a method for making a lithographic printing plate from an original containing continuous tones comprising the steps of:
- frequency modulation screening said original to obtain screened data
- image-wise exposing according to said screened data a negative working photosensitive lithographic printing plate precursor containing a photosensitive layer comprising a direct positive silver halide emulsion and an image receiving layer comprising physical development nuclei in water permeable contact with each other, said lithographic printing plate precursor having a surface capable of being differentiated in ink accepting and ink repellant areas upon said image-wise exposure and an development step and
- developing a thus obtained image-wise exposed lithographic printing plate precursor using an alkaline processing liquid in the presence of developing agent(s) and silver halide solvent(s), characterized in that said photosensitive layer comprises a spectrally sensitized prefogged direct positive silver halide emulsion with exterior electron-traps whereof the amount of silver bromide lies in the range between 0.5 mole/mole AgX and 5 mole/mole AgX.

### 4. Brief description of the drawings.

The present invention is illustrated by way of example and without the intention to limit the invention thereto by means of the following drawing:

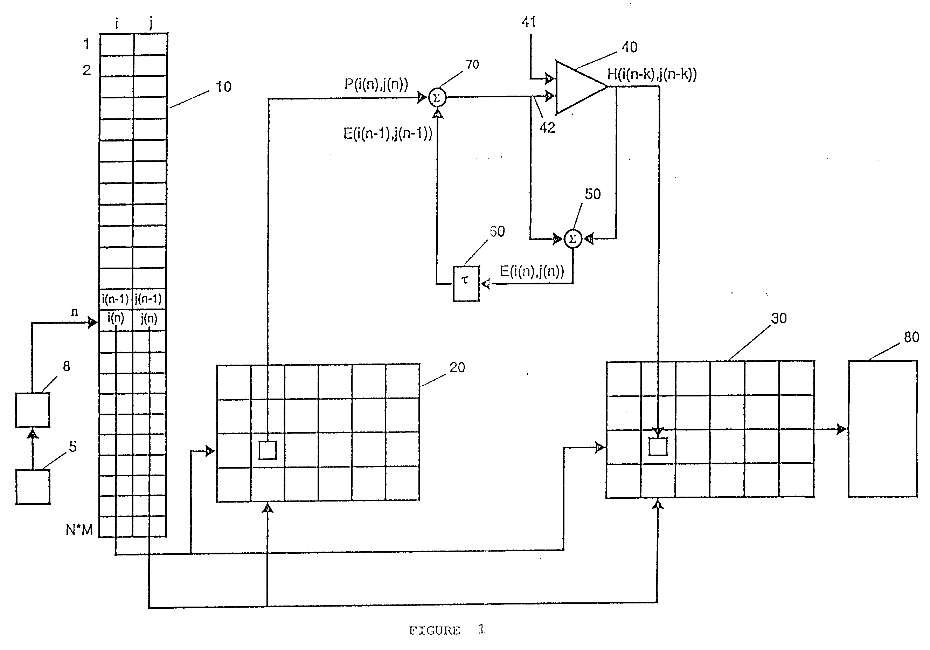

Figure 1 shows a schematic representation of a circuit for implementing a halftoning method suitable for use in the present invention.

### 5. Detailed description of the invention.

Surprisingly, it was found that the tone value reproduction in the case of frequency modulated screening can be considerably improved by the use of a negative working silver complex diffusion transfer reversal (herein after called DTR-) imaging element comprising a spectrally sensitized prefogged direct positive silver halide emulsion with exterior electron-traps whereof the amount of silver bromide lies in the range between 0.5 mole/mole AgX and 5 mole/mole AgX compared to using a conventional negative working PS-plate. The dot gain of the printing plate obtained after image-wise exposure and development of the printing plate precursor is much lower and the tone value range is as a result larger, especially in the shadowy parts where an improved reproduction is obtained. The sensitivity of said imaging element and the printing endurance of the printing plate is high.

The principles of the DTR-process have been described e.g. in US-P 2,352,014 and in the book "Photographic Silver Halide Diffusion Processes" by André Rott and Edith Weyde - The Focal Press - London and New York, (1972).

A DTR-image bearing material can be used as a planographic printing plate wherein the DTR-silver image areas form the water-repellant ink-receptive areas on a water-receptive ink-repellant background. For example, typical lithographic printing plates are disclosed e.g. in EP-A-423399 and EP-A-410500.

The DTR-image can be formed in the image-receiving layer of a sheet or web material which is a separate element with respect to the photographic silver halide emulsion material (a so-called two-sheet DTR element) or in the image-receiving layer of a so-called single-support-element, also called mono-sheet element, which contains at least one photographic silver halide emulsion layer integral with an image-receiving layer in waterpermeable relationship therewith. It is the latter mono-sheet version which is normally used for the preparation of offset printing plates by the DTR- method.

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the (black) silver image obtained in the developed areas of the photographic layer.

In the conventional DTR-process a photosensitive negative silver halide emulsion layer material is used, whereby after exposure and processing a negative image is formed in the silver halide emulsion layer while a positive image is formed in the receiving layer. The conventional DTR-process is thus positive working.

If, like in connection with the present invention a negative image of the (inter)original is to be formed in the receiving layer a positive image should be formed in the silver halide emulsion layer and the DTR process is then negative working.

In the embodiment for obtaining a negative working DTR process according to the present invention, the DTR-imaging element comprises as photographic silver halide emulsion layer a photosensitive layer comprising a spectrally sensitized prefogged direct positive silver halide emulsion whereof the amount of silver bromide lies in the range between 0.5 mole/mole AgX and 5 mole/mole AgX.

Said prefogged direct positive emulsion used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

Preferably the silver halide crystals of said prefogged direct-positive silver halide emulsion contain silver chloride for at least 95 mole/mole AgX, more preferably for at least 97.5 mole/mole AgX. Preferably the amount of silver bromide ranges from 0.5 mole/mole AgX to 2 mole/mole AgX and is homogeneously distributed throughout the silver halide crystals. Also preferably the amount of silver iodide ranges from 0.02 mole/mole AgX to 2 mole/mole AgX, more preferably from 0.05 mole/mole AgX to 1 mole/mole AgX, most preferably from 0.10 mole/mole AgX to 0.5 mole/mole AgX and is preferably located for at least 75 mole% in the outer 10% by weight, more preferably in the outer 5% by weight, most preferably in the outer 2% by weight of the silver halide crystals.

The silver halide crystals can be doped with Rh³⁺, Ir⁴⁺, etc..

The average size of the silver halide grains may range from 0.10 to 0.70 µm , preferably from 0.25 to 0.45 µm.

The silver halide emulsion is desalted by one of the well known techniques e.g. by floculating said silver halide emulsion, washing it with water or an aqueous solution and redispersing it, by ultrafiltration, by dialysis, etc.. Preferably, the desalination of the silver halide emulsion is carried out before the prefogging of the silver halide emulsion, but can also be carried out afterwards.

The prefogging of the silver halide emulsions for use in accordance with the present invention may be effected by overall exposing a silver halide emulsion to light and/or by chemically prefogging a silver halide emulsion. Chemical fog specks are preferred and may be obtained by various methods.

Chemical prefogging may be carried out by reduction or by a compound which is more electropositive than silver e.g. gold salts, platinum salts, iridium salts etc., or a combination of both. Reduction prefogging of the silver halide grains may occur by high pH and/or low pAg silver halide precipitation or digestion conditions e.g. as described by Wood J. Phot. Sci. 1 (1953), 163 or by treatment with reducing agents e.g. tin (II) salts which include tin(II)chloride, tin complexes and tin chelates of (poly)amino(poly)carboxylic acid type as described in British Patent 1,209,050 , formaldehyde, hydrazine, hydroxylamine, sulphur compounds e.g. thiourea dioxide, phosphonium salts e.g. tetra(hydroxymethyl)-phosphonium chloride, polyamines e.g. diethylenetriamine, bis(p-aminoethyl)sulphide and its water-soluble salts, hydrazine derivatives, alkali arsenite, amine borane etc. or mixtures thereof.

In addition to the above described methods of chemically prefogging chemical prefogging can be attained by using said fogging agents in combination with a sulphur-containing sensitizer, e.g. sodium thiosulphate or a thiocyanic acid compound e.g. potassium thiocyanate.

Spectrally sensitized prefogged direct-positive silver halide emulsions with exterior electron-traps are emulsions having absorbed to the surface of the prefogged silver halide grains a electron-accepting dyes which may provide spectral sensitization or not and optionally desensitizing compounds as described in e.g. the British Patent Specification 723,019.

According to Sheppard et al. J. Phys. Chem, 50 (1946), 210; desensitizers are dyestuffs whose cathodic polarographic half-wave potential, measured against the calomel electrode, is more positive than -1.0 V. It is well kown to characterize these electron-accepting or desensitizing compounds by means of their polarographic half-wave potential. Electron acceptors suitable for use in the direct-positive silver halide emulsions of the present invention have an anodic polarographic half-wave potential and a cathodic half-wave potential that when added together give a positive sum. Methods of determining these polarographic half-wave potentials have been described, e.g., in the US-P-3,501,310 and US-P-3,531,290.

Prefogged direct positive silver halide emulsions for use in accordance with the present invention comprise one or more electron-accepting spectral sensitizers as exterior electron trap preferably in a total amount of at least 0.15 mmole/mole AgX, more preferably in a total amount from 0.50 mmole/mole AgX to 2.50 mmole/mole AgX, most preferably in a total amount from 0.85 mmole/mole AgX to 1.80 mmole/mole AgX.

The silver halide emulsion is spectrally sensitized according to the spectral emission of the exposure source for which the photographic element is designed.

Suitable electron-accepting sensitizing dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

Other dyes, which per se do not have any spectral sensitization activity, or certain other compounds, which do not substantially absorb visible radiation, can have a supersensitization effect when they are incorporated together with said spectral electron-accepting sensitizing agents into the emulsion. Suitable supersensitizers are i.a. heterocyclic mercapto compounds containing at least one electronegative substituent as described e.g. in US-A 3,457,078, aromatic organic acid/formaldehyde condensation products as described e.g. in US-A 3,743,510, cadmium salts, and azaindene compounds. Preferred supersensitizers are nitrogen-containing heterocyclic ring-substituted aminostilbene compounds as described e.g. in US-A 2,933,390 and US-A 3,635,721.

Said preferred supersensitizers are preferably used in a total amount of at least 0.20 mmole/mole AgX, more preferably in a total amount from 0.65 mmole/mole AgX to 3.20 mmole/mole AgX, most preferably in a total amount from 1.10 mmole/mole AgX to 2.40 mmole/mole AgX.

Said compounds capable of acting as exterior electron traps and said supersensitizers are preferably added to the silver halide emulsion after the end of the prefogging, more preferably as the next step. When not only electron-accepting spectral sensitizers are used but also other desensitizing dyes or compounds or supersensitizers, said electron-accepting spectral sensitizers are preferably added after the other above mentioned compounds, but they can also be added before or between the addition of said above mentioned compounds.

The pAg at 25°C of the photographic material comprising the spectrally sensitized direct-positive silver halide emulsion layer is preferably at least 6.5, more preferably at least 7, most preferably from 7.4 to 8.5.

The pH at 25°C of the photographic material comprising the spectrally sensitized direct-positive silver halide emulsion layer is preferably at most 7, more preferably at most 6, most preferably from 5.5 to 4.3.

The desired pAg and pH of the photographic material is preferably obtained by bringing the prefogged silver halide emulsion layer to said required pH and pAg.

The required pH of said emulsion layer is obtained by adding pH-regulating compound (acids, bases or buffers) to said emulsion layer.

The desired pAg is preferably obtained by adding water soluble bromide salt(s) to the direct-positive silver halide emulsion just before or after the pH of said direct-positive silver halide emulsion is adjusted, one of these two steps being the last one before said direct-positive silver halide emulsion is coated.

The desired pAg and/or pH of the photographic material can also be obtained by coating an additional layer in water permeable relationship with said prefogged silver halide emulsion layer, containing halides, and/or pH-regulating compounds.

The direct positive silver halide emulsions may contain emulsion stabilizers. Suitable direct positive silver halide emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable direct positive silver halide emulsion stabilizers are i.a. heterocyclic mercapto compounds, quaternary benzothiazole derivatives, and other heterocyclic nitrogen-containing compounds. Examples of such compounds have been disclosed in e.g. EP-A 496127. Other suitable direct positive silver halide emulsion stabilizers are e.g. benzenethiosulphonic acid, benzenethiosulphinic acid, benzenethiosulphonic acid amide. Said stabilizers can be added to the silver halide emulsion prior to, during, or after the prefogging thereof and mixtures of two or more of these compounds can be used.

The direct positive silver halide emulsion may contain other ingredients such as development accelerators, preferably polyalkyleneoxide derivatives having a molecular weight of at least 400 such as those described in e.g. US-P 3,038,805, 4,038,075 and 4,292,400, wetting agents and hardening agents for gelatin may be present. The direct positive silver halide emulsion layer may comprise light-screening dyes that absorb scattering light and thus promote the image sharpness. Suitable light-absorbing dyes are described in i.a. US-P 4,092,168, US-P 4,311,787, DE-P 2,453,217.

More details about the composition, preparation and coating of direct positive silver halide emulsions can be found in e.g. Product Licensing Index, Vol. 92, December 1971, publication 9232, p. 107-109.

The imaging element of the present invention further comprises at least an image receiving layer containing physical development nuclei in water permeable relationship with the photosensitive direct positive silver halide emulsion layer. Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or complexed silver ions.

Preferred physical development nuclei for use in accordance with the present invention are sulphides of heavy metals e.g. sulphides of antimony, bismuth, cadmium, cobalt, lead, nickel, palladium, platinum, silver, and zinc. Especially suitable physical development nuclei in connection with the present invention are palladium sulphide nuclei. Other suitable physical development nuclei are salts such as e.g. selenides, polyselenides, polysulphides, mercaptans, and tin (II) halides. Heavy metals, preferably silver, gold, platinum, palladium, and mercury can be used in colloidal form.

The layer containing physical development nuclei is preferably free of hydrophilic binder but may comprise small amounts upto 80% by weight of the total weight of said layer of a hydrophilic colloid e.g. polyvinyl alcohol to improve the hydrophilicity of the surface.

The photographic material of the present invention may contain additional hydrophilic layers, in water permeable relationship with the photosensitive direct positive silver halide emulsion layer.

For example in a preferred embodiment in connection with the present invention it is especially advantageous to include a base-layer between the support and the photosensitive direct positive silver halide emulsion layer. Said base-layer can serve as an antihalation layer. This layer can therefore contain the same light-absorbing dyes as described above for the direct positive silver halide emulsion layer; as alternative finely divided carbon black can be used for the same antihalation purposes as described in US-P 2,327,828. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the direct positive silver halide emulsion layer the most part however preferably being present in said base-layer. As a further alternative the light reflecting pigments may be present in a separate layer provided between the antihalation layer and the photosensitive direct positive silver halide emulsion layer.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

The imaging element in connection with the present invention preferably also contains a water permeable intermediate layer between the direct positive silver halide emulsion layer and the layer containing physical development nuclei.

The hydrophilic layers usually contain gelatin as hydrophilic colloid binder. Mixtures of different gelatins with different viscosities can be used to adjust the rheological or photographic properties of the layer. Unlike the direct positive silver halide emulsion layer the other hydrophilic layers are coated preferably at a pH value near the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the vinylsulfone type e.g. methylenebis(sulfonylethylene), aldehydes e.g. formaldehyde, glyoxal, and glutaraldehyde, N-methylol compounds e.g. dimethylolurea and methyloldimethylhydantoin, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The imaging element used according to the present invention may further comprise various kinds of surface-active agents in the photographic direct positive silver halide emulsion layer or in at least one other hydrophilic colloid layer. Examples of suitable surface-active agents are described in e.g. EP 545452. Preferably compounds containing perfluorinated alkyl groups are used.

The photographic material of the present invention may further comprise various other additives such as e.g. compounds improving the dimensional stability of the photographic element, UV-absorbers, spacing agents and plasticizers.

Supports suitable for use in accordance with the present invention may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. poly(ethylene terephthalate) film or poly-Alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide. Metal supports e.g. grained, anodized and optionally post-treated aluminum may also be used in accordance with the present invention.

According to one embodiment an imaging element that can be used for obtaining a negative lithographic printing plate according to the DTR-method is obtained by coating on a support in the order given at least one emulsion layer comprising a spectrally sensitized prefogged direct positive silver halide emulsion with exterior electron-traps whereof the amount of silver bromide lies in the range between 0.5 mole/mole AgX and 5 mole/mole AgX and an image receiving layer containing physical development nuclei in water permeable relationship with said direct positive silver halide emulsion layer. Preferably the imaging element also comprises a base layer between the support and the direct positive silver halide emulsion layer as described above. A further intermediate layer between the direct positive silver halide emulsion layer and the layer containing physical development nuclei is also preferred.

A matting agent is preferably included in said base layer and optionally in small amounts i.e. from 1 to 20% by weight in the direct positive silver halide emulsion layer. When the matting agent is included in the direct positive silver halide emulsion layer it is preferable added to the direct positive silver halide emulsion after spectral sensitization of the direct positive silver halide emulsion to avoid adsorption of the sensitizer to the matting agent. Suitable matting agents for use in accordance with the present embodiment are water insoluble inorganic or organic particles having an average diameter between 1µm and 10µm most preferably between 2µm and 8µm. A preferred matting agent is silica.

Preferably used supports in connection with the present embodiment are paper supports or resin supports e.g. polyester film supports.

According to a more preferred embodiment an imaging element that can be used for obtaining a negative lithographic printing plate according to the DTR-method is obtained by coating in the order given on a hydrophilic surface of a support (i) an image receiving layer containing physical development nuclei and (ii) a photosensitive layer comprising a spectrally sensitized prefogged direct positive silver halide emulsion with exterior electron-traps whereof the amount of silver bromide lies in the range between 0.5 mole/mole AgX and 5 mole/mole AgX said photosensitive layer being in water permeable relationship with said image receiving layer. Of course, in this embodiment the layers superlying said image receiving layer will have to be removed during the processing in order to obtain a printing plate.

The hydrophilic surface of a support can be a hardened hydrophilic layer, containing a hydrophilic synthetic homopolymer or copolymer and a hardening agent coated on a flexible support. Preferred hydrophilic layers are layers of polyvinyl alcohol hardened with a tetraalkyl orthosilicate and preferably containing SiO₂ and/or TiO₂ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199 which therefor are incorporated herein by reference.

More preferably an aluminum support is used as a hydrophilic base.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally post-treating of the foil. Preferably the aluminum foil has a roughness with a CLA value between 0.2 and 1.5 µm, an anodization layer with a thickness between 0.4 and 2.0 µm and is post-treated with an aqueous bicarbonate solution.

In connection with the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

Electrochemical graining can be conducted in a hydrochloric and/or nitric acid containing electrolyte solution using an alternating or direct current. Other aqueous solutions that can be used in the electrochemical graining are e.g. acids like HCl, HNO₃, H₂SO₂, H₃PO₄, that if desired, contain additionally one or more corrosion inhibitors such as Al(NO₃)₃, AlCl₃, boric acid, chromic acid, sulfates, chlorides, nitrates, monoamines, diamines, aldehydes, phosphates, H₂O₂, etc. ...

Electrochemical graining in connection with the present invention can be performed using single-phase and three-phase alternating current. The voltage applied to the aluminum plate is preferably 10-35 V. A current density of 3-150 Amp/dm² is employed for 5-240 seconds. The temperature of the electrolytic graining solution may vary from 5-50°C. Electrochemical graining is carried out preferably with an alternating current from 10 Hz to 300 Hz.

The roughening is preferably preceded by a degreasing treatment mainly for removing fetty substances from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

Suitable acids for use in the aqueous etch solution are preferably inorganic acids and most preferably strong acids. The total amount of acid in the aqueous etch solution is preferably at least 150g/l. The duration of chemical etching is preferably between 3s and 5min.

After roughening and optional chemical etching the aluminum foil is anodized which may be carried out as follows.

An electric current is passed through the grained aluminum foil immersed as an anode in a solution containing sulfuric acid, phosphoric acid, oxalic acid, chromic acid or organic acids such as sulfamic, benzosulfonic acid, etc. or mixtures thereof. An electrolyte concentration from 1 to 70 % by weight can be used within a temperature range from 0-70°C. The anodic current density may vary from 1-50 A/dm² and a voltage within the range 1-100 V to obtain an anodized film weight of 1-8 g/m² Al₂O₃.H₂O. The anodized aluminum foil may subsequently be rinsed with demineralised water within a temperature range of 10-80°C.

After the anodizing step a posttreatment such as sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminum". Different types of sealing of the porous anodized aluminum surface exist.

A preferred posttreatment is performed by treating a grained and anodized aluminum support with an aqueous solution containing a bicarbonate as disclosed in EP-A 567178, which therefor is incorporated herein by reference.

Preferably each of the above described steps is separated by a rinsing step to avoid contamination of the liquid used in a particular step with that of the preceding step.

To facilate the removal of the direct positive silver halide emulsion layer and to improve its photographic stability it is advantageous to provide a hydrophilic layer between the image receiving layer and the direct positive silver halide emulsion layer. Preferably used hydrophilic layers for this purpose are layers comprising a hydrophilic non-proteinic film-forming polymer e.g. polyvinyl alcohol, polymer beads e.g. poly(meth)acrylate beads or mixtures thereof. Such type of layers are disclosed in EP-A-483415 and EP-A-410500.

A variant of said two embodiments for an imaging element that can be used for obtaining a negative lithographic printing plate according to the DTR-method comprises a substantially non-light-sensitive layer containing a silver salt between a photosensitive layer comprising a spectrally sensitized prefogged direct positive silver halide emulsion with exterior electron-traps whereof the amount of silver bromide lies in the range between 0.5 mole/mole AgX and 5 mole/mole AgX and a layer containing physical development nuclei. Preferentially, said variant additionally comprises a hydrophylic layer between said direct positive silver halide emulsion layer and said substantially non-light sensitive layer and/or a hydrophilic layer between said direct positive silver halide emulsion layer and said layer of physical development nuclei.

The silver salt particles contained in said substantially non-light-sensitive layer are preferably insoluble in water and are capable of being complexed by a complexing agent present in the diffusion transfer processing liquid. The term "substantially non-light-sensitive layer" means that said layer shows substantially no light-sensitivity towards the light energy necessary to expose the direct positive silver halide emulsion layer and to form a latent image therein.

Said non-light-sensitive water insoluble silver salts may be prepared using the precipitation reaction of the water soluble salt of the desired anion of the insoluble silver salt with a water soluble silver salt, e.g. silver nitrate, in the presence of a hydrophilic binder. Silver halide containing at least 70 mol% of chloride is preferred in the present invention for use as the non-light sensitive water insoluble silver salt. The silver halide is preferably neither chemically sensitized or prefogged nor spectrally sensitized. The silver halide is preferably also doped with Rh³⁺ or Ir⁴⁺ to reduce the light sensitivity of the silver halide.

The original containing continuous tones is screened by frequency modulation screening. Frequency modulation screening is a technique in which the continuously changing tone values of an original are reproduced by means of equally sized micro dots, the number of which is proportional to the tone value of the original image. The name frequency modulation refers to the fact that the number of micro dots per unit surface (the frequency) fluctuates in proportion to the tone value in that same area.

Various dot frequency modulation screening techniques suitable for use in connection with the present invention have been disclosed and they can be divided into the following subclasses:
1) Point to Point thresholding based techniques,
2) Error Diffusion along a line by line, column by column scan (and variations).
3) Error Propagation along a Hilbert scan (and variations).
4) Special techniques.

A special technique is disclosed in DE 2,931,092, and further developed in US 4,485,397.

The most representative technique of point to point thresholding is the halftoning based on the "Bayer" dither matrix Bayer, B.E., "An optimum method for two level rendition of continuous-tone pictures", Proc. IEEE International Conference on Communications, Conference Record, pp. (26-11), (26-15)., 1973. This Bayer dither matrix has a size that is a power of two, and contains threshold values that are arranged in such a fashion that, when thresholded against increasing levels of density, every halftone dot is "as far away as possible" from the halftone dots that are used to render the lower density levels.

A number of variations on this technique are developed. A method is disclosed in US Serial No 08/106.333 wherein said frequency modulation screening of an original comprises the steps of: (i) generating a non-halftone value; (ii) altering said non-halftone value at a higher tone resolution than the tone resolution of said original and (iii) utilizing said altered non-halftone value to produce a halftone value for the frequency modulated halftone screening.

Another method is disclosed in US Serial No 08/116.254 wherein said frequency modulation screening of an original originates a halftone screen having a plurality of halftone dots, at least some of which have a size greater than the size of a pixel of said contone original and at least some of which have a size equal to the size of a pixel of said contone original. Said methods may be used alone or in combination.

Another Point to Point thresholding technique uses a "Blue Noise Mask" instead of a Bayer dither matrix. It is described in US 5,111,310. The Blue Noise Mask is the result of an optimization (filtering) performed iteratively (for the subsequent threshold "layers") on the Fourier transform of the threshold matrix.

Another frequency modulation screening techniques suitable for use in connection with the present invention is the well known Error diffusion first described by Floyd and Steinberg "An adaptive algorithm for spatial grey scale" SID 75 Digest. Society for information display 1975, pp. 36-37. According to the error diffusion technique the image pixels of a continuous tone image are processed one after the other according to a predetermined path e.g. from left to right and top to bottom.

The tone value of each image pixel is thereby compared with a threshold value which is generally the tone value half-way the tone scale e.g. 128 when the tones of the image-pixels range from 0 to 256. Depending on whether the tone value of the image pixel is above or below the threshold value a halftone dot will be set or not in the corresponding reproduction of the image pixel. The resulting error or weighted error, i.e. the difference between the reproduction value and actual value of the image pixel, is then added to the tone value of one or more neighbouring image pixels that are still unprocessed. Details about the error diffusion screening method may be found in the aforementioned reference or in US-P-5.175.804.

A more preferred variant of frequency modulation screening for use in connection with the present invention is a method similar to the error diffusion with the exception that the order in which the image pixels are processed can be described by a space filling deterministic fractal curve or a randomized space filling curve.

This type of frequency modulation screening comprises the following steps:
- selecting an unprocessed image pixel from the original continuous tone image according to a space filling deterministic fractal curve or a randomized space filling curve and processing said unprocessed image pixel as follows:
- determining from the tone value of said unprocessed image pixel a reproduction value to be used for recording said image pixel on a recording medium e.g. a photographic film or lithographic printing plate precursor,
- calculating an error value on the basis of the difference between said tone value of said unprocessed image pixel and said reproduction value, said unprocessed image pixel thereby becoming a processed image pixel,
- adding said error value to the tone value of an unprocessed image pixel and replacing said tone value with the resulting sum or alternatively distributing said error value over two or more unprocessed image pixels by replacing the tone value of each of said unprocessed image pixels to which said error value will be distributed by the sum of the tone value of the unprocessed image pixel and part of said error,
- repeating the above steps until all image pixels are processed.

A suitable deterministic fractal curve is for example the so called "Hilbert Curve" disclosed by Witten Ian H., and Radford M. Neal, "Using Peano Curves for Bilevel Display of Continuous-Tone Images", IEEE CG&A, May 1982, pp. 47-52.

According to a particularly preferred embodiment in connection with the present invention the order of processing the image pixels is ruled by a randomized space filling curve. With the term "randomized space filling curve" is meant that the processing of the image pixels follows basically a pre-determined curve that assures that each image pixel will be processed but which curve is randomized at a number of points so that patterns are avoided.

According to an alternative a randomized space filling curve may be obtained by dividing the image into matrices of image pixels. Within each of these matrices the image pixels are processed at random untill all image pixels are processed. The order in which the matrices are processed may then be selected at random or in a predetermined way.

The most preferred alternative over the above method of dividing the image into matrices is the recursively division of the image into smaller matrices untill the size of a matrix reaches an image pixel. At every subdivision into smaller submatrices a random ordering of processing the matrices is assigned to every submatrix. More details on these screening techniques are disclosed in e.g. EP-A 571.010 and EP-A 93201114.1, which therefor are hereby incorporated by reference.

Figure 1 shows a circuit to perform a frequency modulation screening in combination with a binary recording device, e.g. an image-setter. First the different building blocks of this circuit are described, later on its operation will be explained.

Block (20) is a memory block containing the contone pixel values of an image. Typically these are 8 bit values, organized as N lines with M columns. Block (30) is a memory block with the same lay out as block (20), in which the the halftoned pixel values will be stored. In the case of a binary recording device, every halftoned pixel word has a length of 1 bit. Block (80) is a device capable of image-wise exposing a substrate e.g. a photographic film or a lithographic printing plate precursor using the information in block (30). Block (70) is an arithmetic unit capable of calculating the sum of the pixelvalue P(i,j) and the error E at the output of a delay register (60). The conversion of a contone pixel value into a halftoned pixel value takes place in block (40). This conversion may be based on a thresholding operation: if the contone value at point (i,j) is below the value of 128, a value "0" is stored in the halftone memory, otherwise a "1" is stored. Block (50) contains an arithmetic unit that is capable to calculate the error between the original contone value, and the halftoned pixel value, and to store it in the delay register (60). Block (8) is a counter that sequences the processing of the N*M pixels of the image. Block (10) is LUT with N*M entries (one for every image pixel), and a UNIQUE combination of a row and column address that corresponds with one pixel position in the image. Block (5) is a clock.

The table of block (10) thus holds the order in which the image pixels will be processed. This table may be calculated according to one of the methods described above.

The operation of the diagram is now explained. At every clock pulse, the counter (8) is incremented, and a new pair of coordinates (i(n),j(n)) is obtained from block (10). These coordinates are used as address values to the pixel memory (20), to obtain a contone pixel value P(i(n),j(n)). This pixel value is immediately added to the error E(i(n-1),j(n-1)), that was stored in register (60) after the previous halftone step, and the sum of both is compared to the threshold value (41) in block (40). The outcome of the thresholding operation determines the value H(i(n),j(n)) that will be written into the halftone pixel memory at position (i(n),j(n)). At the same time a new error E(i(n),j(n)) is calculated from the difference between P(i(n),j(n)) and H(i(n),j(n)), and stored in the delay register (60). The circuit is initialized by setting the counter (8) to 1, the error to 128, and the operation is terminated when the counter reaches the level N*M. After that, the halftone memory (30) is read out line by line, column by column, and its contents are recorded on a substrate by the recorder (80).

According to a variant of the above circuit the error that is obtained from the difference between the contone pixel and the halftoned pixel value, may, instead of being diffused only to the next pixel in the order of processing, diffused to more than one of the unprocessed pixels. Instead of using the error of one pixel, one may also use an average error of a number of pixels.

In case of a color image, the above described screening process is performed on each of the color separations of the image. Preferably the color image is separated in its Yellow, Magenta, Cyan and Black components. Each of these components may then be screened and used to image-wise expose four lithographic printing plate precursors according to the present invention. Four lithographic printing plates, one for each color separation, will thus be obtained. The color separations can then be printed over each other in register in a lithographic printing machine using the four plates.

According to a preferred embodiment of the present invention the CMYK color separations are prepared starting from a device independent representation of the color image. More details on this technique are disclosed in e.g. WO 94/06242, which therefor is incorporated hereby for reference.

Image-wise exposure in accordance with the present invention may proceed by a scan-wise exposure by means of e.g. a laser or LED directly according to said screened data on the printing plate precursor (so called computer to plate) or it may be performed by first exposing according to said screened data an intermediate photographic film of high contrast, generally a high contrast silver halide film, and then using the imaged photographic film as a mask for exposing a lithographic printing plate precursor to a conventional light source in a camera exposure or contact exposure.

Suitable devices for said scan-wise exposure are e.g. Cathode Ray Tubes, LED's or, most preferably lasers.

Examples of lasers that can be used in connection with the present invention are e.g. He/Ne lasers, Argon ion lasers, semiconductor lasers, YAG lasers e.g. Nd-YAG lasers etc..

Photographic films and printing plate precursors having a flexible support can be exposed using a drum scanner. Examples of such exposure units containing a HeNe laser are the image-setters LINOTRONIC 300, marketed by LINOTYPE-HELL Co, and Select 5000/7000, marketed by Miles Inc.. Such an image-setter provided with an Ar ion laser that can be used is LS 210, marketed by Dr-Ing RUDOLF HELL GmbH. Such exposure units provided with a laserdiode that can be used are LINOTRONIC 200, marketed by LINOTYPE-HELL Co, and ACCUSET marketed by Miles Inc..

Because of the stifness of an aluminum support this type of imaging elements is preferably exposed using a flat-bed scanner.

To obtain a negative lithographic printing plate according to the present invention an above described DTR-imaging element comprising a spectrally sensitized prefogged direct positive silver halide emulsion with exterior electron-traps wherein the amount of silver bromide lies in the range between 0.5 mole/mole AgX and 5 mole/mole AgX is information-wise exposed as described above and is subsequently developed with an alkaline processing liquid in the presence of developing agent(s) and silver halide solvent(s).

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. However other developing agents can be used. Said developing agents may be contained in an alkaline processing liquid but are preferably contained in one or more layers of the photographic element. In the latter case the alkaline processing liquid merely serves as an alkaline activating liquid.

The pH of said alkaline liquid is preferably between 9 and 14, more preferably between 10 and 13 and may be established by an organic and/or inorganic alkali agent. Examples of suitable alkali agents are e.g. sodium hydroxide, carbonates, phosphates, alkanolamines or mixtures thereof.

The alkaline processing liquid preferably also contains a preserving agent having antioxidation activity, e.g. sulphite ions. Further may be present a thickening agent, fog inhibiting agents, calcium-sequestering compounds, anti-sludge agents, development accelerators and hardeners including latent hardeners.

Suitable silver complexing agents also called silver halide solvents for use in accordance with the present invention are e.g. thiosulphate or thiocyanate in an amount ranging from 5 g to 20 g per liter. Other interesting silver halide complexing agents are e.g. sulphite, amines, 2-mercaptobenzoic acid, cyclic imide compounds such as e.g. uracil, 5,5-dialkylhydantoins, alkyl sulfones and oxazolidones.

Further silver halide solvents for use in connection with the present invention are alkanolamines. Said alkanolamines may be present in the alkaline processing liquid in a concentration preferably between 0.1% and 5% by weight. However part or all of the alkanolamine can be present in one or more layers of the imaging element.

Still other preferred further silver halide solvents for use in connection with the present invention are thioethers, preferably di- or poly-thioethers as disclosed in e.g. US-P-4.960.683 and EP-A 554,585.

Still further suitable silver halide solvents are meso-ionic compounds, preferably 1,2,4-triazolium-3-thiolates.

Combinations of different silver halide solvents can be used and it is also possible to incorporate at least one silver halide solvent into a suitable layer of the imaging element and to add at least one other silver halide solvent to the developing or activating solution. Preferably they are comprised in the alkaline processing liquid.

After the above described processing a silver image is obtained in the layer containing physical development nuclei.

In case the imaging element is obtained by coating on a support in the order given at least one photosensitive layer comprising a spectrally sensitized prefogged direct positive silver halide emulsion with exterior electron-traps wherein the amount of silver bromide lies in the range between 0.5 mole/mole AgX and 5 mole/mole AgX and an image receiving layer containing physical development nuclei the development step is preferably followed by a neutralization of the surface of the imaged element by guiding the element through a neutralization liquid having a pH between 4 and 7. The neutralization liquid preferably contains a buffer e.g. a phosphate buffer, a citrate buffer, an amine or a mixture thereof. The neutralization solution can further contain bactericides, e.g. phenol, thymol or 5-bromo-5-nitro-1,3-dioxan as described in EP-150,517, wetting agents e.g. saponins or pluronics etc.. The liquid can also contain substances which influence the hydrophobic / hydrophilic balance of the printing plate obtained after processing of the DTR element, e.g. silica. Finally the neutralization solution can contain wetting agents, preferably compounds containing perfluorinated alkyl groups.

To improve the differentiation between the hydrophobic silver image and the hydrophilic background the alkaline processing liquid and/or neutralization liquid preferably contain one or more hydrophobizing agents, e.g. those described in US-P-3,776,728, and US-P-4,563,410. Preferred hydrophobizing agents are mercapto-1,3,4-thiadiazoles as described in DE-A 1,228,927 and in US-P 4,563,410, 2-mercapto-5-alkyl-oxa-3,4-diazole and long chain (at least 5 carbon atoms) alkyl substituted mercaptotetrazoles.

In case the imaging element is obtained by coating in the order given on a hydrophilic surface of a support (i) an image receiving layer containing physical development nuclei and (ii) a photosensitive layer comprising a spectrally sensitized prefogged direct positive silver halide emulsion with exterior electron-traps wherein the amount of silver bromide lies in the range between 0.5 mole/mole AgX and 5 mole/mole AgX the imaging element is subsequently treated to remove the layer(s) on top of the image receiving layer, preferably by rinsing the imaging element with water, thereby exposing the imaged surface of the support by uncovering said silver image formed in said image receiving layer. Finally the hydrophobic character of the silver image is preferably improved using a finishing liquid comprising hydrophobizing agents as described above.

The present invention is illustrated with the following examples without limiting it thereto. All parts are by weight unless otherwise specified.

### EXAMPLE

### Preparation of prefogged direct-positive silver halide emulsions I.

A gelatin silver halide emulsion of grain size 0.26 µ (98.7 mol% of chloride and 1.3 mol% of bromide) was prepared by double jet precipitation. 35 Minutes after the end of the precipitation the emulsion is flocculated and washed with demineralized water. The washed gelatino silver halogenide emulsion was peptised with low viscosity (14 mPas) Ca²⁺-free gelatin and was subsequently fogged by addition of potassium chloroaurate (1.2 mg per mole of silver halide) at pH 7 and pAg 6, at a temperature of 52 °C for 5 hours.
To the emulsion was added at 40 °C under continuously stirring the desensitizing dye chinolinium, 1-methyl-5-ethoxy-2-[3-nitrophenyl] ethenyl, methylsulfaat (4.6 mg/g AgNO₃) and 20 minutes later the electron accepting spectral sensitizer A (5.6 mg/g AgNO₃). So, gelatin prefogged direct-positive silver halide emulsion I was obtained.

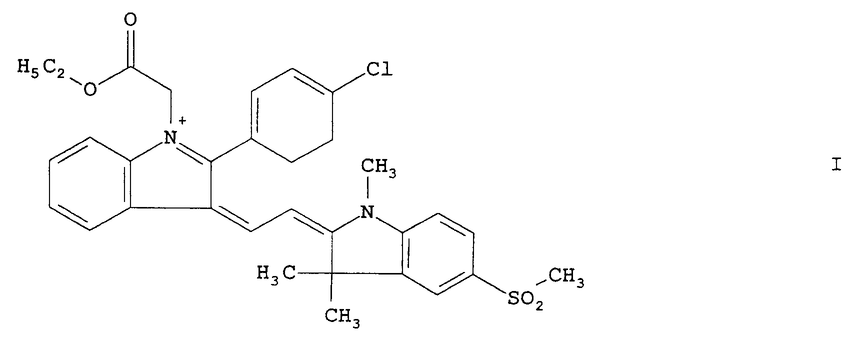

### Preparation of the negative working DTR plate 1.

A 0,30 mm thick aluminum foil (AA 1050) was electrochemically grained, subsequently subjected to anodic oxidation in a 20 % sulfuric acid aqueous solution to form an anodic oxidation film of 3.0 g/m² of Al₂O₃.H₂O,) treated with an aqueous solution containing 20 g/l of NaHCO₃ at 45°C for 30 sec and then rinsed with demineralised water and dried.

The imaging element was obtained by coating the grained, anodized and sealed aluminum support with a silver-receptive stratum containing 1.1 mg/m² PdS as physical development nuclei.

An intermediate layer was then provided on the dry silver-receptive stratum from an aqueous composition in such a way that the resulting dried layer had a weight of 0.5 g of polymethyl methacrylate beads per m², said composition comprising:

| | |
|---|---|
| a 20 % dispersion of polymethyl methacrylate beads in a mixture of equal volumes of water and ethanol having an average diameter of 1.0 µm | 50 ml |
| Helioechtpapierrot BL (trade mark for a dye sold by BAYER AG, D-5090 Leverkusen, West-Germany) | 2.5 g |
| saponine | 2.5 g |
| sodium oleylmethyltauride | 1.25 g |
| demineralized water (pH-value : 5.6) | 300 ml |

Finally the prefogged direct-positive silver halide emulsion I was coated on the intermediate layer after adjusting at 40°C the pH at 5 with sulfuric acid and the pAg at 7.5 with potassium bromide, with the silver halide being provided in an amount corresponding to 2.40 g of silver nitrate per m² and the gelatin content of the emulsion layer being 1.58 g/m², consisting of 0.7 g/m² of a Ca²⁺-free gelatin with a viscosity of 21 mPa.s and the remainder of the Ca²⁺-containing gelatin with a viscosity of 14 mPa.s

An original was screened at 2400 dpi according to a frequency modulation screening wherein the image pixels were processed in a random order by recursively subdividing the image of the original into matrices until the size of a matrix matched the size of an image pixel. The error for each image pixel was added to the tone value of the next image pixel processed. A high contrast silver halide intermediate film was scan-wise exposed in accordance with the obtained screened data and after a classical processing used as a mask for exposing a lithographic printing plate precursor to a conventional light source.

The negative working DTR plate **1** and two examples of commercial negative working photopolymer PS plates: a Fuji FNS plate (available from FUJI Co, Japan) and an OZASOL-N61 plate (available from FUJI Co, Japan) were illuminated by contact exposure through said negative mask film. Exposure was such as to obtain 8 µ negative microlines open on the plate.

The negative working DTR plate **1** was exposed on a Theimer contact illumination instrument, during 16 seconds, to obtain the said illumination criterium. Processing was carried out by immersing the exposed plate for 10 s at 24°C in L5000 developer. The initiated diffusion transfer was allowed to continue for 30 s to form a silver image in the image receiving layer.

To remove the developed silver halide emulsion layer and the intermediate layer from the aluminum foil the developed monosheet DTR material was rinsed for 6 s with a water jet at 40°C.

Next, the imaged surface of the aluminum foil was guided for 15 s through L 5300 finisher having a temperature of 40°C. L5000/L5300 developer/finisher chemistry are both available from AGFA-GEVAERT N.V..

The FUJI FNS plate was illuminated on a CDL1000S instrument during 1100 time units to fit the said illumination criterium. It was subsequently manually processed in EN143 processing solution (available from FUJI Co, Japan) and then rinsed with water.

The OZASOL N 61 plate was illuminated during 1168 time units on a CDL1000S processor to fit the 8 µ microline criterium. It was manually processed in DN-3C processing solution and rinsed with water and an OZASOL-N61 plate (both available from KALLE A.G., Germany)

The so obtained 3 plates were printed on a Heidelberg GTO 52 printing press equiped with a Dahlgren dampener. Hartmann S6920 ink was used and Rotamatic 100 % was the fountain solution used. Prints were made on Zanders Ikonorex 115 g/m² paper at a speed of 5000 prints per hour. A density of 1.85 (FOGRA standard) on solid areas was maintained (Gretag D186). Densities were measured with a Macbeth RD918 densitometer according to the Murray-Davis formula.

After about 200 prints, when good quality prints were obtained, the following screen densities were measured on paper:

| Screening % on original | Screening % on print from the following negative working PS-plate | | |
|---|---|---|---|
| | FUJI FNS | OZASOL N61 | Neg plate **1** |
| 1 | 3 | 3 | 2 |
| 2 | 7 | 5 | 4 |
| 3 | 12 | 8 | 5 |
| 4 | 14 | 11 | 7 |
| 5 | 21 | 15 | 10 |
| 7 | 27 | 22 | 14 |
| 10 | 37 | 30 | 20 |
| 15 | 52 | 45 | 32 |
| 20 | 64 | 58 | 43 |
| 30 | 77 | 75 | 58 |
| 40 | 88 | 86 | 73 |
| 50 | 94 | 93 | 83 |
| 60 | 97 | 97 | 90 |
| 70 | 99 | 99 | 95 |
| 80 | 100 | 100 | 98 |

### Evaluation:

From the above it is clear that when the original has been screened according to a frequency modulation screening technique in order to obtain an internegative film, prints from a printing plate obtained by exposing through said internegative film and processing the negative working DTR printing plate **1** the increase in tone value is substantially less than what is observed by using the commercially available negative working PS plates Fuji FNS plate or OZASOL-N61 plate. This allows a better tone value range for DTR plates since heavily shaded parts are less readily clogged. Therefor less tone value corrections are needed, causing less decrease of the reproducible grey values.

## Claims

1. A method for making a lithographic printing plate from an original containing continuous tones comprising the steps of:
- frequency modulation screening said original to obtain screened data
- image-wise exposing according to said screened data a negative working photosensitive lithographic printing plate precursor containing a photosensitive layer comprising a direct positive silver halide emulsion and an image receiving layer comprising physical development nuclei in water permeable contact with each other, said lithographic printing plate precursor having a surface capable of being differentiated in ink accepting and ink repellant areas upon said image-wise exposure and an development step and
- developing a thus obtained image-wise exposed lithographic printing plate precursor using an alkaline processing liquid in the presence of developing agent(s) and silver halide solvent(s), characterized in that said photosensitive layer comprises a spectrally sensitized prefogged direct positive silver halide emulsion with exterior electron-traps whereof the amount of silver bromide lies in the range between 0.5 mole/mole AgX and 5 mole/mole AgX.

2. A method according to claim 1 wherein said amount of silver bromide lies in the range between 0.5 mole/mole AgX and 2 mole/mole AgX.

3. A method according to claim 1 wherein said spectrally sensitized prefogged direct positive silver halide emulsion with exterior electron-traps whereof the amount of silver bromide lies in the range between 0.5 mole/mole AgX and 5 mole/mole AgX comprises silver iodide in the range from 0.02 mole/mole AgX to 2 mole/mole AgX.

4. A method according to any of claims 1 to 3 wherein said negative working photosensitive lithographic printing plate precursor is obtained by coating on a support in the order given at least one photosensitive layer comprising a spectrally sensitized prefogged direct positive silver halide emulsion with exterior electron-traps whereof the amount of silver bromide lies in the range between 0.5 mole/mole AgX and 5 mole/mole AgX and an image receiving layer containing physical development nuclei.

5. A method according to any of claims 1 to 3 wherein said negative working photosensitive lithographic printing plate precursor is obtained by coating in the order given on a grained, anodized and optionally post-treated surface of an aluminum foil (i) an image receiving layer containing physical development nuclei and (ii) a Photosensitive layer comprising a spectrally sensitized prefogged direct positive silver halide emulsion with exterior electron-traps whereof the amount of silver bromide lies in the range between 0.5 mole/mole AgX and 5 mole/mole AgX.

6. A method according to any of claims 1 to 5 wherein said frequency modulation screening of an original Proceeds according to the following steps:
- selecting an unprocessed image pixel of an original according to a space filling deterministic fractal curve or a randomized space filling curve and processing said unprocessed image pixel as follows:
- determining from the tone value of said unprocessed image pixel a reproduction value to be used for recording said image pixel on a recording medium,
- calculating an error value on the basis of the difference between said tone value of said unprocessed image pixel and said reproduction value, said unprocessed image pixel thereby becoming a processed image pixel,
- adding said error value to the tone value of an unprocessed image pixel and replacing said tone value with the resulting sum or alternatively distributing said error value over two or more unprocessed image pixels by replacing the tone value of each of said unprocessed image pixels to which said error value will be distributed by the sum of the tone value of the unprocessed image pixel and part of said error,
- repeating the above steps until all image pixels are processed.

7. A method according to any of claims 1 to 5 wherein said frequency modulation screening of an original comprises the steps of:
- generating a deterministic frequency modulation screen function using a dither matrix that has a size that is a power of two, and contains threshold values that are arranged in such a fashion that, when thresholded against increasing levels of density, every halftone dot is "as far away as possible" from the halftone dots that are used to render the lower density levels;
- locally randomizing said deterministic frequency modulation screen function; and
- utilizing said locally-randomized deterministic frequency modulation screen function to produce the frequency modulation halftone screen.

8. A method according to claim 7 wherein said frequency modulation screening of an original comprises the steps of:
- generating a non-halftone value;
- altering said non-halftone value at a higher tone resolution than the tone resolution of said original
- utilizing said altered non-halftone value to produce a halftone value for the frequency modulated halftone screening.

9. A method according to claim 7 or 8 wherein said frequency modulation screening of an original originates a halftone screen having a plurality of halftone dots, at least some of which have a size greater than the size of a pixel of said contone original and at least some of which have a size equal to the size of a pixel of said contone original .

10. A method according to any of the above claims wherein the image-wise exposure of the negative working photosensitive lithographic printing plate precursor according to said screened data is a scan-wise exposure using a laser or LED.
